# EUROPEAN PATENT APPLICATION

(11) **EP 4 800 841 A1**
(43) Date of publication of application: **02.09.2026**
(21) Application number: 24895730.0
(22) Date of filing: 07.08.2024
(51) Int. Cl.: H01Q 1/52

(54) **ANTI-INTERFERENCE STRUCTURE, HOUSING ASSEMBLY, AND ELECTRONIC DEVICE**

(30) Priority: 30.11.2023 CN 202311637515
(71) Applicant: Honor Device Co., Ltd., Shenzhen, Guangdong 518040 (CN)
(72) Inventor: WU, Dong, Shenzhen, Guangdong 518040 (CN); SHI, Longfei, Shenzhen, Guangdong 518040 (CN); ZHU, Kaixiang, Shenzhen, Guangdong 518040 (CN); LIANG, Feng, Shenzhen, Guangdong 518040 (CN)
(74) Representative: Goddar, Heinz J.
(86) International application number: PCT/CN2024/110249
(87) International publication number: WO 2025/112627

(57) **Abstract**

Embodiments of this application relate to the field of electronic device technologies, and provide an anti-interference structure, a housing assembly, and an electronic device. The anti-interference structure includes an antenna, a camera module, and an electrically conductive member. The electrically conductive member is located in a space between the antenna and the camera module. An electromagnetic wave radiated by the antenna may excite, on the electrically conductive member, a first standing wave propagating in a first direction, the first standing wave includes a first electric field, and the first electric field is capable of causing a first current flowing in the first direction to be generated on a side of the electrically conductive member facing the first standing wave. The anti-interference structure includes a first conduction loss member, the first conduction loss member is located on the side of the electrically conductive member facing the first standing wave, and a material of the first conduction loss member is a current loss material; or a material of a part of the side of the electrically conductive member facing the first standing wave is a current loss material. The anti-interference structure, the housing assembly, and the electronic device provided in embodiments of this application effectively improve an interference problem caused by the first standing wave on the camera module.

## Description

This application claims priority to Chinese Patent Application No. 202311637515.8, filed with the China National Intellectual Property Administration on November 30, 2023 and entitled "ANTI-INTERFERENCE STRUCTURE, HOUSING ASSEMBLY, AND ELECTRONIC DEVICE", which is incorporated herein by reference in its entirety.

### TECHNICAL FIELD

This application relates to the field of electronic device technologies, and in particular, to an anti-interference structure, a housing assembly, and an electronic device.

### BACKGROUND

To implement a communication function, some electronic devices usually need to be provided with various antennas for signal transmission, so as to transmit and receive signals. To meet requirements of communication in a plurality of frequency bands, there are also an increasing number of types of antennas in electronic devices such as a mobile phone, a tablet, and a smartwatch. To meet usage requirements, other functional modules such as a camera module are also integrated into the electronic device.

During use of a conventional electronic device, because both the antenna and the camera module are disposed inside the electronic device, a radio frequency signal transmitted from the antenna is likely to interfere with the camera module. Consequently, the camera module suffers from phenomena such as blurry screen, frame freezing, and frozen screen due to the interference, resulting in poor user experience.

### SUMMARY

Embodiments of this application provide an anti-interference structure, a housing assembly, and an electronic device, to improve a problem in the related art that when an electronic device is in use, a camera module is interfered due to a signal transmitted by an antenna.

To achieve the foregoing objective, the following technical solutions are used in embodiments of this application.

According to a first aspect, an embodiment of this application provides an anti-interference structure, where the anti-interference structure includes an antenna, a camera module, and an electrically conductive member. The electrically conductive member is located in a space between the antenna and the camera module, an electromagnetic wave radiated by the antenna is capable of exciting, on the electrically conductive member, a first standing wave propagating in a first direction, the first standing wave includes a first electric field, and the first electric field is capable of causing a first current flowing in the first direction to be generated on a side of the electrically conductive member facing the first standing wave.

The anti-interference structure includes a first conduction loss member, the first conduction loss member is located on the side of the electrically conductive member facing the first standing wave, and a material of the first conduction loss member is a current loss material; or a material of a part of the side of the electrically conductive member facing the first standing wave is a current loss material.

The anti-interference structure provided in this embodiment of this application has at least the following technical effects:

The anti-interference structure includes the first conduction loss member, the first conduction loss member is located on the side of the electrically conductive member facing the first standing wave, and the material of the first conduction loss member is the current loss material, or the material of the part of the side of the electrically conductive member facing the first standing wave is the current loss material. Therefore, when the electromagnetic wave radiated by the antenna excites, on the electrically conductive member, the first standing wave propagating in the first direction, the current loss material may convert the first current generated by the first electric field of a part of the first standing wave on the electrically conductive member into thermal energy, to prevent the first current from forming a changing first magnetic field again, so that an intensity of the first magnetic field of the first standing wave and an intensity of the first electric field can both be weakened. Therefore, an overall intensity of the first standing wave is weakened, and a propagation distance of the first standing wave is shortened. In this way, superposition of the first electric field/first magnetic field and an electric field/a magnetic field that carries an image information signal and that is on an MIPI line of the camera module is avoided, thereby effectively improving an interference problem caused by the first standing wave on the camera module.

In some of the embodiments, a conductivity of the current loss material in first direction is less than or equal to 8000 S/m within a temperature range of -50 °C to 200 °C.

In some of the embodiments, the conductivity of the current loss material in the first direction is less than or equal to 3000 S/m.

In some of the embodiments, the anti-interference structure includes a first conduction loss member, the first conduction loss member is located on the side of the electrically conductive member facing the first standing wave, the material of the first conduction loss member is the current loss material, and the first conduction loss member is disposed on the side of the electrically conductive member facing the first standing wave by adhesion, soldering, snap-fit, threaded connection, or evaporation.

In some of the embodiments, the anti-interference structure includes the first conduction loss member, the first conduction loss member is located on the side of the electrically conductive member facing the first standing wave, the material of the first conduction loss member is the current loss material, and a distance between the first conduction loss member and the electrically conductive member is less than or equal to 2 mm.

In some of the embodiments, the first conduction loss member is disposed on an outer surface of the electrically conductive member.

In some of the embodiments, the electrically conductive member is at least one of a bracket, a main board, a decorative member, a heat sink, or a shielding cover.

In some of the embodiments, the current loss material is one of an alloy material, a semiconductor material, and a clay material.

According to a second aspect, an embodiment of this application provides an anti-interference structure, where the anti-interference structure includes an antenna and a camera module, an electromagnetic wave radiated by the antenna is capable of exciting, on the camera module, a second standing wave propagating in a second direction, the second standing wave includes a second electric field, and the second electric field is capable of causing a second current flowing in the second direction to be generated on a side of the camera module facing the second standing wave, where
the anti-interference structure includes a second conduction loss member, the second conduction loss member is located on the side of the camera module facing the second standing wave, and a material of the second conduction loss member is a current loss material; or a material of a part of the side of the camera module facing the second standing wave is a current loss material.

The anti-interference structure provided in this embodiment of this application has at least the following technical effects:

The anti-interference structure includes the second conduction loss member, the second conduction loss member is located on the side of the camera module facing the second standing wave, and the material of the second conduction loss member is the current loss material, or the material of the part of the side of the camera module facing the second standing wave is the current loss material. Therefore, when the electromagnetic wave radiated by the antenna excites, on the camera module, the second standing wave propagating in the second direction, the current loss material may convert the second current generated by the second electric field of a part of the second standing wave on the camera module into thermal energy, to prevent the second current from forming a changing second magnetic field again, so that an intensity of the second magnetic field of the second standing wave and an intensity of the second electric field are both weakened. Therefore, an overall intensity of the second standing wave is weakened, and a propagation distance of the second standing wave is shortened. In this way, superposition of the second electric field/second magnetic field and an electric field/a magnetic field that carries an image information signal and that is on an MIPI line of the camera module is avoided, thereby effectively improving an interference problem caused by the second standing wave on the camera module.

According a third aspect, an embodiment of this application provides a housing assembly, where the housing assembly includes:
a housing; and
the anti-interference structure according to the first aspect or the second aspect, where the anti-interference structure is connected to the housing.

The housing assembly provided in this embodiment of this application has at least the following technical effects:
The anti-interference structure includes the first conduction loss member, the first conduction loss member is located on the side of the electrically conductive member facing the first standing wave, and the material of the first conduction loss member is the current loss material, or the material of the part of the side of the electrically conductive member facing the first standing wave is the current loss material. Therefore, when the electromagnetic wave radiated by the antenna excites, on the electrically conductive member, the first standing wave propagating in the first direction, the current loss material may convert the first current generated by the first electric field of a part of the first standing wave on the electrically conductive member into thermal energy, to prevent the first current from forming a changing first magnetic field again, so that an intensity of the first magnetic field of the first standing wave and an intensity of the first electric field can both be weakened. Therefore, an overall intensity of the first standing wave is weakened, and a propagation distance of the first standing wave is shortened. In this way, superposition of the first electric field/first magnetic field and an electric field/a magnetic field that carries an image information signal and that is on an MIPI line of the camera module is avoided, thereby effectively improving an interference problem caused by the first standing wave on the camera module.

The anti-interference structure includes the second conduction loss member, the second conduction loss member is located on the side of the camera module facing the second standing wave, and the material of the second conduction loss member is the current loss material, or the material of the part of the side of the camera module facing the second standing wave is the current loss material. Therefore, when the electromagnetic wave radiated by the antenna excites, on the camera module, the second standing wave propagating in the second direction, the current loss material may convert the second current generated by the second electric field of a part of the second standing wave on the camera module into thermal energy, to prevent the second current from forming a changing second magnetic field again, so that an intensity of the second magnetic field of the second standing wave and an intensity of the second electric field are both weakened. Therefore, an overall intensity of the second standing wave is weakened, and a propagation distance of the second standing wave is shortened. In this way, superposition of the second electric field/second magnetic field and an electric field/a magnetic field that carries an image information signal and that is on an MIPI line of the camera module is avoided, thereby effectively improving an interference problem caused by the second standing wave on the camera module.

In some of the embodiments, the electromagnetic wave radiated by the antenna is capable of exciting, on the housing, a third standing wave propagating in a third direction, the third standing wave includes a third electric field, and the third electric field is capable of causing a third current flowing in the third direction to be generated on a side of the housing facing the third standing wave.

The anti-interference structure includes a third conduction loss member, the third conduction loss member is located on the side of the housing facing the third standing wave, and a material of the third conduction loss member is a current loss material; or a material of a part of the side of the housing facing the third standing wave is a current loss material.

According to a fourth aspect, an embodiment of this application provides an electronic device, and the electronic device includes the housing assembly according to the third aspect.

The electronic device provided in this embodiment of this application has at least the following technical effects:

The anti-interference structure includes the first conduction loss member, the first conduction loss member is located on the side of the electrically conductive member facing the first standing wave, and the material of the first conduction loss member is the current loss material, or the material of the part of the side of the electrically conductive member facing the first standing wave is the current loss material. Therefore, when the electromagnetic wave radiated by the antenna excites, on the electrically conductive member, the first standing wave propagating in the first direction, the current loss material may convert the first current generated on the electrically conductive member by the first electric field of a part of the first standing wave into thermal energy, to prevent the first current from forming a changing first magnetic field again, so that an intensity of the first magnetic field of the first standing wave and an intensity of the first electric field can both be weakened. Therefore, an overall intensity of the first standing wave is weakened, and a propagation distance of the first standing wave is shortened, thereby effectively improving an interference problem caused by the first standing wave on the camera module.

The anti-interference structure includes the second conduction loss member, the second conduction loss member is located on the side of the camera module facing the second standing wave, and the material of the second conduction loss member is the current loss material, or the material of the part of the side of the camera module facing the second standing wave is the current loss material. Therefore, when the electromagnetic wave radiated by the antenna excites, on the camera module, the second standing wave propagating in the second direction, the current loss material may convert the second current generated on the camera module by the second electric field of a part of the second standing wave into thermal energy, to prevent the second current from forming a changing second magnetic field again, so that an intensity of the second magnetic field of the second standing wave and an intensity of the second electric field both be weakened. Therefore, an overall intensity of the second standing wave is weakened, and a propagation distance of the second standing wave is shortened, thereby effectively improving an interference problem caused by the second standing wave on the camera module.

In some of the embodiments, the electronic device includes a screen module, the electromagnetic wave radiated by the antenna is capable of exciting, on the screen module, a fourth standing wave propagating in a fourth direction, the fourth standing wave includes a fourth electric field, and the fourth electric field is capable of causing a fourth current flowing in the fourth direction to be generated on a side of the screen module facing the fourth standing wave.

The anti-interference structure includes a fourth conduction loss member, the fourth conduction loss member is located on the side of the screen module facing the fourth standing wave, and a material of the fourth conduction loss member is a current loss material; or a material of a part of the side of the screen module facing the fourth standing wave is a current loss material.

### BRIEF DESCRIPTION OF DRAWINGS

FIG. 1 is a three-dimensional assembly view of a housing assembly according to Embodiment 1 of this application;
FIG. 2 is a three-dimensional exploded view of the housing assembly shown FIG. 1;
FIG. 3 is a three-dimensional diagram of a bracket in the housing assembly shown FIG. 1;
FIG. 4 is a model diagram of an anti-interference structure in the housing assembly shown in FIG. 1;
FIG. 5 is a schematic diagram of relative positions of the bracket in the anti-interference structure shown in FIG. 4, a first conduction loss member, and a main board;
FIG. 6 is a schematic simulation diagram of isolation of an antenna-mobile industry processor interface (Mobile Industry Processor Interface, MIPI) in a conventional housing assembly;
FIG. 7 is a schematic simulation diagram of a staggered distribution diagram of an electric field and a magnetic field on an electrically conductive member in a conventional housing assembly;
FIG. 8 is a schematic diagram of comparison simulation of electric field intensity between an electrically conductive member having a conductivity that is respectively 1000 S/m and 3000 S/m at a first conduction loss member in a housing assembly according to Embodiment 1 of this application and an electrically conductive member in a standing wave mode in a conventional housing assembly;
FIG. 9 is a comparison diagram of isolation between an electrically conductive member in the housing assembly shown in FIG. 1 and an anti-interference structure in a conventional housing assembly;
FIG. 10 is a schematic diagram of relative positions of a bracket in an anti-interference structure, a first conduction loss member, and a main board according to Embodiment 2 of this application;
FIG. 11 is a comparison diagram of isolation between an electrically conductive member in the housing assembly shown in FIG. 10 and an anti-interference structure in a conventional housing assembly;
FIG. 12 is a schematic diagram of relative positions of a bracket in an anti-interference structure and a main board according to Embodiment 3 of this application;
FIG. 13 is a comparison diagram of isolation between an electrically conductive member in the housing assembly shown in FIG. 12 and an anti-interference structure in a conventional housing assembly;
FIG. 14 is a schematic diagram of relative positions of a bracket in an anti-interference structure, a first conduction loss member, and a main board according to Embodiment 4 of this application;
FIG. 15 is a schematic diagram of relative positions of a bracket in an anti-interference structure, a first conduction loss member, and a main board according to Embodiment 5 of this application;
FIG. 16 is a three-dimensional diagram of a decorative member in the housing assembly shown FIG. 1;
FIG. 17 is a three-dimensional diagram of a shielding cover in the housing assembly shown FIG. 1;
FIG. 18 is a three-dimensional diagram of a camera module in the housing assembly shown FIG. 1;
FIG. 19 is a three-dimensional diagram of the housing assembly shown in FIG. 1 from another perspective; and
FIG. 20 is a three-dimensional diagram of the housing assembly shown in FIG. 1 from still another perspective.

Reference numerals in the accompanying drawings are as follows.
100. Housing assembly;
10. Antenna;
20. Camera module; 21. Flexible printed circuit board;
30. Electrically conductive member;
40. First conduction loss member;
50. Main board;
60. Second conduction loss member;
70. Housing; 71. Middle frame; 72. Third conduction loss member;
80. Screen module; 81. Screen; 82. Fourth conduction loss member.

### DESCRIPTION OF EMBODIMENTS

The following describes embodiments of this application in detail. Examples of the embodiments are shown in the accompanying drawings, and same or similar reference signs in all the accompanying drawings indicate same or similar elements or elements having same or similar functions. The embodiment described below with reference to the accompanying drawings are examples of embodiments and is intended for explaining this application, and should not be construed as a limitation on this application.

In the description of this application, it should be understood that, orientations or position relationships indicated by terms such as "length", "width", "thickness", "top", "bottom", "inner", "outer", "above", "below", "left", and "right" are orientations or position relationships shown based on the accompanying drawings, and are merely intended to facilitate description of this application and simplify description, rather than indicate or imply that a mentioned apparatus or element should have a particular orientation, and is constructed and operated in a specific orientation, and therefore, shall not be understood as a limitation on this application.

Terms such as "first", "second", "third", and "fourth" are used only to distinguish descriptions, and shall not be understood as an indication or implication of relative importance or implicit indication of a quantity of indicated technical features. For example, a first pushing portion and a second pushing portion are merely intended to distinguish between different pushing portions, and do not limit a sequence thereof. The first pushing portion may alternatively be named the second pushing portion, and the second pushing portion may alternatively be named the first pushing portion, without departing from the scope of the described embodiments. In addition, the terms such as "first", "second", "third", and "fourth" do not limit that the indicated features are necessarily different.

In this application, unless otherwise explicitly specified and defined, terms such as "connected" and "connection" should be understood in a broad sense. For example, the connection may be a fixed connection, a detachable connection, or an integral connection; or the connection may be a mechanical connection or an electrical connection; or the connection may be a direct connection, an indirect connection through an intermediary, or internal communication between two elements or an interaction relationship between two elements. A person of ordinary skill in the art may understand specific meanings of the foregoing terms in this application according to specific situations.

In this application, "and/or" is merely an association relationship for describing associated objects and represents that three relationships may exist. For example, A and/or B may represent: Only A exists, both A and B exist, and only B exists. In addition, the character "/" in this specification generally represents an "or" relationship between the associated objects.

It should be noted that, in this application, words such as "in an embodiment", "exemplary", and "for example" are used to represent giving an example, an illustration, or a description. Any embodiment or design solution described as "in an embodiment", "exemplary", and "for example" in this application should not be explained as being more preferable or more advantageous than another embodiment or design solution. Exactly, use of the word "in an embodiment", "exemplary", "for example" or the like is intended to present a related concept in a specific manner.

To make the objectives, technical solutions, and advantages of this application clearer and more understandable, this application is further described in detail below with reference to the accompanying drawings and the embodiments.

During use of a conventional electronic device, because both an antenna and a camera module are disposed inside the electronic device, when the antenna transmits a signal, the camera module is prone to be interfered. Consequently, the camera module suffers from interference phenomena such as blurry screens, frame freezing, and frozen screens, resulting in poor user experience.

The electronic device is further equipped with an electrically conductive member such as a bracket, a main board, a decorative member (Deco), a heat sink, and a shielding cover. When the antenna transmits a radio frequency signal, a wavelength of an electromagnetic wave radiated by the antenna corresponds to a size of the electrically conductive member. For example, when the size of the electrically conductive member is equal to or close to a quarter or a half of the wavelength of the electromagnetic wave, the electrically conductive member is coupled to the electromagnetic wave radiated by the antenna, and standing waves are generated in these electrically conductive members.

The standing wave includes a changing magnetic field and a changing electric field. The changing electric field causes movement of electrons in the electrically conductive member, to generate, on a surface of the electrically conductive member, a changing current flowing in a propagation direction of the standing wave. The changing current generates the changing magnetic field. A position of a magnetic field intensity point has the strongest current on the surface of the electrically conductive member, and the changing magnetic field generates the changing electric field. As the foregoing process is repeated, the standing wave propagates near the camera module.

The standing wave has an electric field intensity point/a magnetic field intensity point in a propagation direction of the standing wave, and the electrically conductive member has a position corresponding to the electric field intensity point/the magnetic field intensity point. Consequently, extremely strong near field coupling easily occurs between the electrically conductive member at the position corresponding to the electric field intensity point/the magnetic field intensity point and the camera module. An electric field/a magnetic field carrying an image information signal on an MIPI line of the camera module and an electric field/a magnetic field of the standing wave are superimposed on each other, to form a superimposed signal. When the superposed signal is transmitted to a system on chip (System on Chip, SoC) for demodulation, the SoC cannot demodulate the superposed signal, resulting in an interference problem in the camera module.

In addition, the camera module, a housing of the electronic device, and a screen module may also be conductive. When the antenna transmits the radio frequency signal, the wavelength of the electromagnetic wave radiated by the antenna corresponds to sizes of the camera module, the electronic device, and the screen module. For example, when the sizes of the camera module, the electronic device, and the screen module are all equal to or close to the quarter or the half of the wavelength of the electromagnetic wave, the camera module, the electronic device, and the screen module are coupled to the electromagnetic wave radiated by the antenna, and the standing waves are generated in the camera module, the electronic device, and the screen module.

In view of this, an embodiment of this application provides an anti-interference structure, a housing assembly, and an electronic device, which can improve the foregoing technical problem.

The electronic device provided in embodiments of this application may be an electronic device having an antenna and a camera module, such as a mobile phone, a tablet computer, a wearable device (such as a watch), a personal digital assistant (Personal Digital assistant, PDA), a notebook computer, an augmented reality (Augmented Reality, AR)/a virtual reality (Virtual Reality, VR) device, or a vehicle-mounted device, but is not limited thereto. In this embodiment of this application, an example in which the electronic device is a mobile phone is used for description.

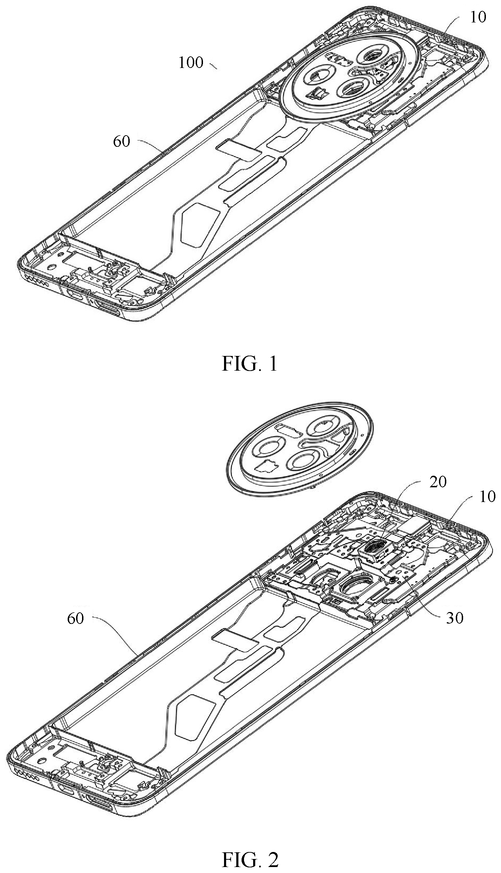

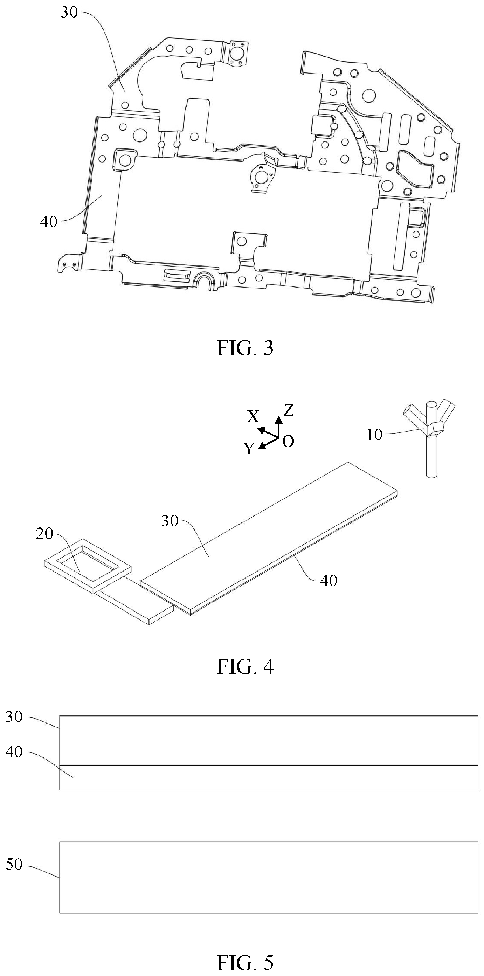

Referring to FIG. 1, FIG. 2, FIG. 3, FIG. 4, and FIG. 5, FIG. 1 is a three-dimensional assembly view of a housing assembly 100 according to an embodiment of this application; FIG. 2 is a three-dimensional exploded view of the housing assembly 100 shown in FIG. 1; FIG. 3 is a three-dimensional diagram of a bracket in the housing assembly shown in FIG. 1; FIG. 4 is a model diagram of an anti-interference structure in the housing assembly 100 shown in FIG. 1; and FIG. 5 is a schematic diagram of relative positions of the bracket in the anti-interference structure shown in FIG. 4, a first conduction loss member 40, and a main board 50.

According to a first aspect, Embodiment 1 of this application provides an anti-interference structure, used in an electronic device. The electronic device further includes a housing 70, and the housing 70 is connected to the anti-interference structure.

The anti-interference structure includes an antenna 10, a camera module 20, and an electrically conductive member 30. The electrically conductive member 30 is located in a space between the antenna 10 and the camera module 20. An electromagnetic wave radiated by the antenna 10 may excite, on the electrically conductive member 30, a first standing wave propagating in a first direction, the first standing wave includes a first electric field, and the first electric field is capable of causing a first current flowing in first direction to be generated on a side of the electrically conductive member 30 facing the first standing wave.

The anti-interference structure includes a first conduction loss member 40, the first conduction loss member 40 is located on the side of the electrically conductive member 30 facing the first standing wave, and a material of the first conduction loss member 40 is a current loss material; or a material of a part of the side of the electrically conductive member 30 facing the first standing wave is a current loss material.

It should be noted that, the antenna 10 is an element configured to receive and send the radio frequency signal on the electronic device, and may radiate the electromagnetic wave. For example, the antenna 10 may be a 5G WIFI antenna or a 5G N78 antenna. In addition, the antenna 10 may have a plurality of frequency bands. The antenna 10 sends the radio frequency signal, and the antenna 10 radiates the electromagnetic wave.

In an example, the antenna 10 may be integrated into the housing 70 of the electronic device. Specifically, the antenna 10 may be located in a middle frame 71 of the housing 70. In this way, not only the antenna 10 can be better protected, but also interference from other components can be avoided, thereby improving quality of signal receiving. In addition, the middle frame 71 may further provide stable support and fixing for the antenna 10. The antenna 10 is integrated in the middle frame 71 of the housing 70 to improve overall aesthetics and integrity of the mobile phone.

The camera module 20 may include a camera configured to daylight image, and the camera module 20 may be further divided into a front-facing camera module 20 and a rear-facing camera module 20. A plurality of the front-facing camera modules and a plurality of the rear-facing camera modules may be disposed.

In addition, a material of the electrically conductive member 30 may be a metal or another conductive material. Specifically, the electrically conductive member 30 may include a bracket, a main board 50, a decorative member (Deco), a heat sink, a shielding cover, and the like of the electronic device. In this embodiment, the electrically conductive member 30 is the bracket.

The electrically conductive member 30 is located in the space between the antenna 10 and the camera module 20. Specifically, the antenna 10 defines a first plane (not shown in the figure), and the camera module 20 defines a second plane (not shown in the figure). The two planes are both perpendicular to the first direction. The electrically conductive member 30 is located in a space between the first plane and the second plane, and is not only located on a connection line between the antenna 10 and the camera module 20.

In this embodiment, the anti-interference structure includes the first conduction loss member 40, and the first conduction loss member 40 is located on the side of the electrically conductive member 30 facing the first standing wave. Specifically, the first conduction loss member 40 may be located between the electrically conductive member 30 and the main board 50.

The first conduction loss member 40 may be connected to the electrically conductive member 30 in a manner such as bonding, welding, clamping, or screw connection. Alternatively, the current loss material is directly evaporated on the electrically conductive member 30, so that the current loss material forms the first conduction loss member 40. The current loss material indicates a material capable of losing a current, and has a capability of absorbing a current. Specifically, it means that the current is absorbed in the current loss material, current energy is converted in the current loss material, to form energy in another form, and a magnetic field is not generated.

For example, the current loss material may be a material having a low conductivity, and can convert a current into thermal energy. Conductivity is a measurement value indicating an intensity of a current transmission capability of a material. The conductivity is defined by using Ohm's law as a ratio of a current density to an electric field intensity, and the conductivity is a reciprocal of a resistivity. A unit of the electrical conductivity in the International System of Units is Siemens per meter (S/m).

Specifically, the first conduction loss member 40 may be disposed only on the side of the electrically conductive member 30 on which the first standing wave is located. When the first standing wave is generated on the surface of the electrically conductive member 30, the first conduction loss member 40 may cover the electrically conductive member 30.

For example, referring to FIG. 4, in this embodiment, the electrically conductive member 30 is located in the space between the antenna 10 and the camera module 20. The electromagnetic wave radiated by the antenna 10 may excite, on the electrically conductive member 30, the first standing wave propagating in the first direction. The first direction is a Y direction in the figure, a direction of the first magnetic field of the first standing wave is parallel to an X direction in the figure, a direction of a first electric field of the first standing wave is parallel to a Z direction in the figure, and a conduction direction of the first current is in the Y direction in the figure.

In another embodiment, the material of the part of the side of the electrically conductive member 30 facing the first standing wave is the current loss material. In this way, a part of the current may be directly converted through the electrically conductive member 30.

It may be understood that, the material of the part of the side of the electrically conductive member 30 facing the first standing wave is the current loss material; or a material of the entire electrically conductive member 30 is the current loss material.

It should be noted that, the current loss material may be one of an alloy material, a semiconductor material, and a clay material, to facilitate the first conduction loss member 40 to be manufactured by using the current loss material. The alloy material may be specifically nickel-chromium, inconel, manganin, constantan, or the like. The semiconductor material may be specifically silicon, germania, or the like, and the clay material may be specifically carbon clays, or the like. The current loss material can absorb current energy and convert the current energy into thermal energy.

In the first direction, when the electromagnetic wave radiated by the antenna 10 excites, on the electrically conductive member 30, the first standing wave propagating in the first direction, the current loss material may convert the first current generated on the electrically conductive member 30 by the first electric field of a part of the first standing wave into thermal energy, to prevent the first current from forming a changing first magnetic field again, so that an intensity of the first magnetic field of the first standing wave is gradually weakened, and an intensity of the first electric field of the first standing wave is also weakened. Therefore, an overall intensity of the first standing wave is weakened, and a propagation distance of the first standing wave is shortened. In this way, superimposition of the first electric field/first magnetic field and an electric field/a magnetic field that carries an image information signal and that is on an MIPI line of the camera module 20 is avoided, thereby effectively improving an interference problem caused by the first standing wave on the camera module 20.

It may be understood that, from an overall perspective, since some energy of the first standing wave is converted into energy in another form by using the current loss material, the overall intensity of the first standing wave is weakened, so that the propagation distance of the first standing wave is shortened, thereby effectively improving the interference problem caused by the first standing wave on the camera module 20.

It can be learned from the foregoing that, according to the anti-interference structure provided in this embodiment of this application, the anti-interference structure includes the first conduction loss member 40, the first conduction loss member 40 is located on the side of the electrically conductive member 30 facing the first standing wave, and the material of the first conduction loss member 40 is the current loss material, or the material of the part of the side of the electrically conductive member 30 facing the first standing wave is the current loss material. Therefore, when the electromagnetic wave radiated by the antenna 10 excites, on the electrically conductive member 30, the first standing wave propagating in the first direction, the current loss material may convert the first current generated on the electrically conductive member 30 by the first electric field of a part of the first standing wave into thermal energy, to prevent the first current from forming a changing first magnetic field again, so that an intensity of the first magnetic field and an intensity of the first electric field of the first standing wave can both be weakened. Therefore, an overall intensity of the first standing wave is weakened, and a propagation distance of the first standing wave is shortened. In this way, superposition of the first electric field/first magnetic field and an electric field/a magnetic field that carries an image information signal and that is on an MIPI line of the camera module 20 is avoided, thereby effectively improving the interference problem caused by the first standing wave on the camera module 20.

The anti-interference structure provided in this embodiment of this application can efficiently decoupling of the camera module 20 and the antenna 10, thereby resolving an anti-interference problem of the camera module 20. Compared with a conventional grounding manner such as a conductive fabric or a conductive foam required for grounding, the anti-interference structure provided in this embodiment of this application can save space and avoid problems such as radiated spurious emission (Radiated Spurious Emission, RSE). The anti-interference structure provided in this embodiment of this application is applicable to a decoupling problem of any frequency band, and has no defect of frequency band limitation; and the anti-interference structure provided in this embodiment of this application also has benefits for resolving a problem of clutters of the antenna 10.

It may be understood that, in the electronic device, devices such as the camera module 20, the screen module 80, a printed circuit board (Printed Circuit Board, PCM) softboard, and a power supply may also radiate an electromagnetic wave. For example, the image information signal carried on the MIPI line of the camera module 20 propagates in a form of an electromagnetic wave. The electromagnetic wave radiated by the devices such as the camera module 20, the screen module 80, the PCB softboard, and the power supply may also excite a standing wave on the electrically conductive member 30. The excited standing wave is coupled to the antenna 10, and affects the antenna 10 to receive the electromagnetic wave sent from a base station. Consequently, receiving sensitivity of the antenna 10 is deteriorated. The anti-interference structure provided in this embodiment of this application may also be configured to improve an interference problem caused by devices such as the camera module 20, the screen module 80, the PCB softboard, and the power supply that can radiate the electromagnetic wave on the antenna 10. A principle of the anti-interference structure is the same as a principle of improving the interference problem of the camera module 20.

Referring to FIG. 2, FIG. 3, and FIG. 4, in Embodiment 1, a conductivity of the current loss material in the first direction is less than or equal to 8000 S/m within a temperature range of -50 °C to 200 °C.

By using the foregoing solution, the current loss material can convert a large part of the first current into thermal energy, so that the intensity of the first magnetic field and the intensity of the first electric field of the first standing wave are both weakened, thereby weakening the overall intensity of the first standing wave, and shortening the propagation distance of the first standing wave.

It may be understood that the temperature range of -50 °C to 200 °C is a common use environment temperature range of an electronic device. A specific material and situation need to be considered to determine whether the conductivity is directional. For a common material, the conductivity is isotropic, that is, the conductivity measured in different directions is the same. Therefore, for these materials, there is no directionality in the conductivity. In this case, it is ensured that the conductivity of the current loss material in all directions are less than or equal to 8000 S/m.

Optionally, to enable the current loss material to convert the large part of the first current into thermal energy, and further weaken the intensity of the first magnetic field of the first standing wave, the conductivity of the current loss material in the first direction is less than or equal to 3000 S/m.

Optionally, the anti-interference structure includes the first conduction loss member 40, the first conduction loss member 40 is located on the side of the electrically conductive member 30 facing the first standing wave, the material of the first conduction loss member 40 is the current loss material, and a distance between the first conduction loss member 40 and the electrically conductive member 30 is less than or equal to 2 mm.

By using the foregoing solution, it is convenient to set relative positions of the first conduction loss member 40 and the electrically conductive member 30, and the large part of the first current can be converted into thermal energy by using the first conduction loss member 40.

In this embodiment, the first conduction loss member 40 is disposed on an outer surface of the electrically conductive member 30. Through this disposition, it is convenient to set a position of the first conduction loss member 40, and the larger part of the first current can be converted into thermal energy by using the first conduction loss member 40.

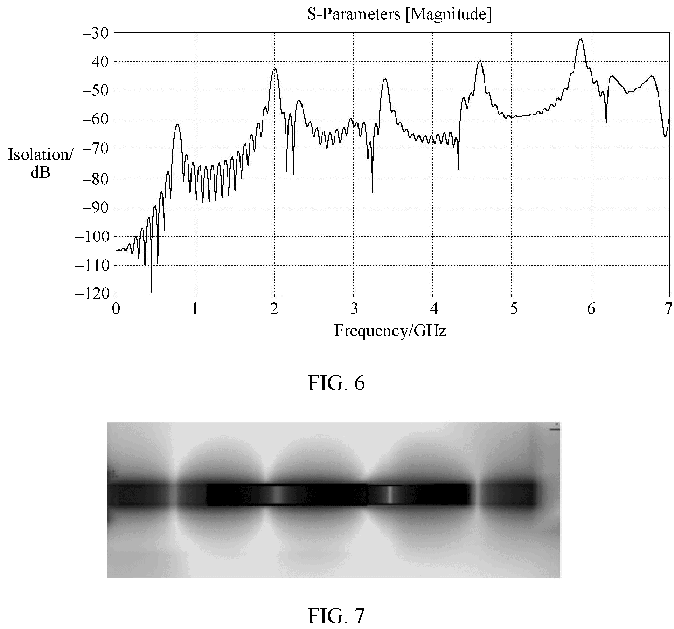

Referring to FIG. 6 and FIG. 7, FIG. 6 is a schematic simulation diagram of isolation of an antenna 10-mobile industry processor interface (Mobile Industry Processor Interface, MIPI) in a conventional housing assembly 100, and FIG. 7 is a schematic simulation diagram of a staggered distribution diagram of an electric field and a magnetic field on an electrically conductive member 30 in a conventional housing assembly 100.

It can be seen from FIG. 6 that, by calculating isolation of the antenna 10-MIPI, it can be found that there are some frequencies of the antenna 10 with poor isolation, and a related frequency easily causes a problem of interference to the camera module 20.

It can be seen from FIG. 7 that, a main physical mechanism for poor isolation of the related frequency is that a standing wave mode of an entire device architecture is excited, and the first standing wave is excited on the electrically conductive member 30. Compared with a non-standing wave mode state, an electric field/a magnetic field intensity point of the standing wave mode causes near field coupling between the bracket and the antenna 10 to be greatly enhanced.

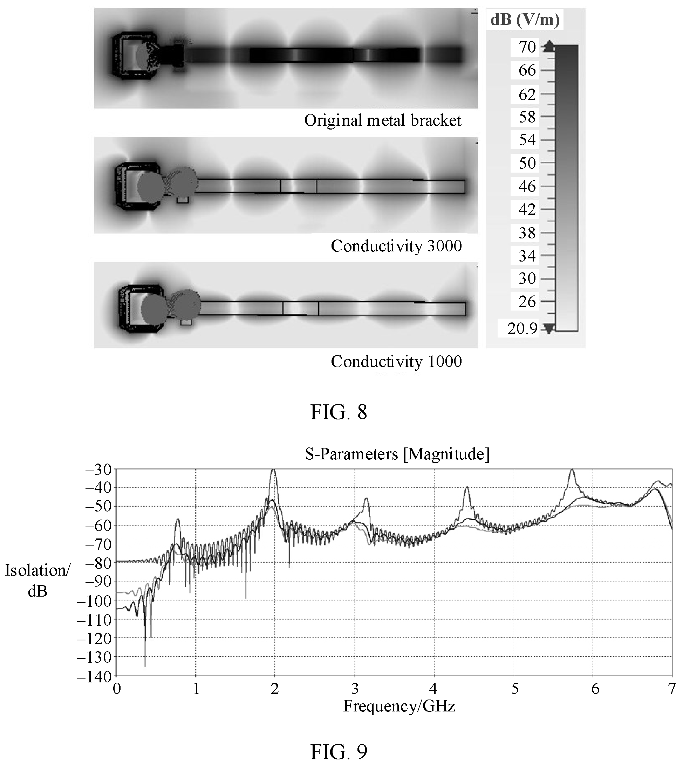

Referring to FIG. 8 and FIG. 9, FIG. 8 is a schematic diagram of comparison simulation of electric field intensity between an electrically conductive member 30 having a conductivity that is respectively 1000 S/m and 3000 S/m at a first conduction loss member 40 in a housing assembly according to Embodiment 1 of this application and an electrically conductive member 30 in a standing wave mode in a conventional housing assembly 100, and FIG. 9 is a comparison diagram of isolation between an electrically conductive member 30 in the housing assembly 100 shown in FIG. 1 and an anti-interference structure in a conventional housing assembly 100.

It can be seen from FIG. 8 that, the first conduction loss member 40 weakens intensity of the first electric field of the first standing wave in the standing wave mode, and as the conductivity decreases, field intensity of the electric field becomes weaker. In this way, an electromagnetic loss is implemented, and the interference problem caused by the first standing wave on the camera module 20 can be effectively improved.

It can be seen from FIG. 9 that, as the conductivity of the first conduction loss member 40 decreases, a value of the isolation also continuously increases.

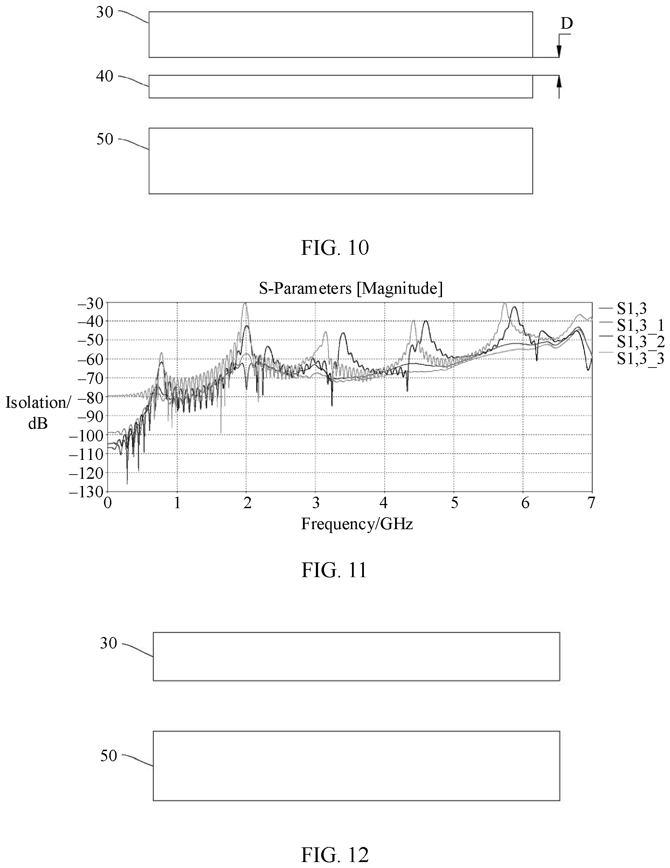

Referring to FIG. 10 and FIG. 11, FIG. 10 is a schematic diagram of relative positions of a bracket in an anti-interference structure, a first conduction loss member 40, and a main board 50 according to Embodiment 2 of this application, and FIG. 11 is a comparison diagram of isolation between an electrically conductive member 30 in the housing assembly 100 shown in FIG. 10 and an anti-interference structure in a conventional housing assembly 100.

A difference from Embodiment 1 lies in that, in this embodiment, the first conduction loss member 40 is located between the bracket and the main board 50, and gaps exist between the first conduction loss member 40 and the bracket, and between the first conduction loss member 40 and the main board 50.

Curves in FIG. 11 are, from top to bottom, respectively an isolation curve of the conventional housing assembly 100, an isolation curve of the antenna 10-MIPI when the first conduction loss member 40 is a common metal, an isolation curve of the antenna 10-MIPI when the conductivity of the first conduction loss member 40 is 3000 S/m, and an isolation curve of the antenna 10-MIPI when the conductivity of the first conduction loss member 40 is 1000 S/m.

It can be seen from FIG. 11, a solution in which the first conduction loss member 40 is located between the bracket and the main board 50, and gaps exist between the first conduction loss member 40 and the bracket and between the first conduction loss member 40 and the main board 50 also has an effect on improving the isolation. In addition, an effect of improving the isolation is more obvious as the conductivity of the first conduction loss member 40 decreases.

In this embodiment, the first conduction loss member 40 is bonded to the bracket. Therefore, a gap exists between the first conduction loss member 40 and the bracket.

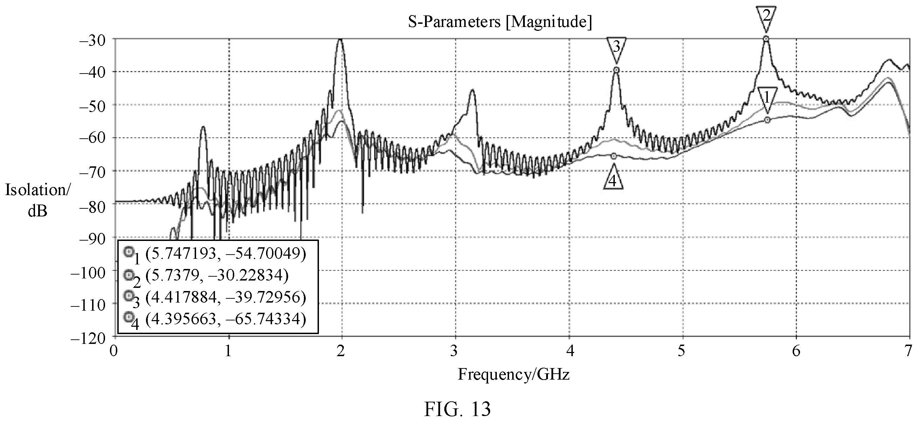

Referring to FIG. 12 and FIG. 13, FIG. 12 is a schematic diagram of relative positions of a bracket in an anti-interference structure and a main board 50 according to Embodiment 3 of this application, and FIG. 13 is a comparison diagram of isolation between an electrically conductive member 30 in the housing assembly 100 shown in FIG. 12 and an anti-interference structure in a conventional housing assembly 100.

A difference from Embodiment 1 lies in that, in this embodiment, a material of the bracket is the current loss material.

Curves in FIG. 13 are, from top to bottom, respectively an isolation curve of the conventional housing assembly 100, an isolation curve of the antenna 10-MIPI when a conductivity of the bracket is 3000 S/m, and an isolation curve of the antenna 10-MIPI when the conductivity of the bracket is 1000 S/m.

It can be seen from FIG. 11 that, setting the material of an entire bracket as the current loss material also has an effect on improving the isolation. In addition, an effect of improving the isolation is more obvious as the conductivity of the bracket decreases.

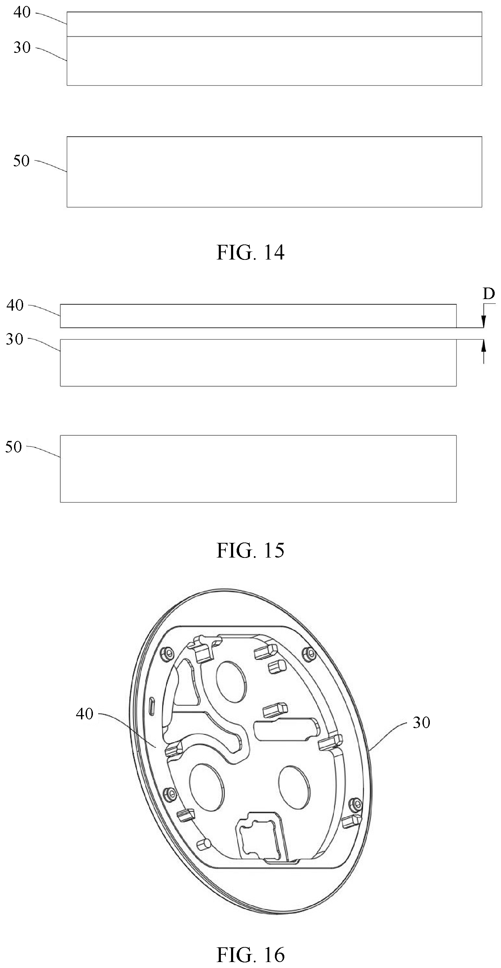

FIG. 14 is a schematic diagram of relative positions of a bracket in an anti-interference structure, a first conduction loss member 40, and a main board 50 according to Embodiment 4 of this application.

A difference from Embodiment 1 lies in that, in this embodiment, the first conduction loss member 40 is located on the side of the electrically conductive member 30 facing the first standing wave. Specifically, the first conduction loss member 40 may be located on a side of the electrically conductive member 30 facing away from the main board 50.

By using the foregoing solution, when the electromagnetic wave radiated by the antenna 10 excites, on the electrically conductive member 30, the first standing wave propagating in the first direction, the current loss material may convert the first current generated on the electrically conductive member 30 by the first electric field of a part of the first standing wave into thermal energy, to prevent the first current from forming a changing first magnetic field again, so that the intensity of the first magnetic field of the first standing wave and the intensity of the first electric field are both weakened. Therefore, the overall intensity of the first standing wave is weakened, the propagation distance of the first standing wave is shortened, thereby effectively improving the interference problem caused by the first standing wave on the camera module 20.

FIG. 15 is a schematic diagram of relative positions of a bracket in an anti-interference structure, a first conduction loss member 40, and a main board 50 according to Embodiment 5 of this application.

A difference from Embodiment 4 lies in that, in this embodiment, in this embodiment, the first conduction loss member 40 is located on the side of the electrically conductive member 30 facing the first standing wave. Specifically, the first conduction loss member 40 may be located on the side of the electrically conductive member 30 facing away from the main board 50, and a gap may exist between the first conduction loss member 40 and the electrically conductive member 30.

By using the foregoing solution, when the electromagnetic wave radiated by the antenna 10 excites, on the electrically conductive member 30, the first standing wave propagating in the first direction, the current loss material may convert the first current generated on the electrically conductive member 30 by the first electric field of a part of the first standing wave into thermal energy, to prevent the first current from forming a changing first magnetic field again, so that the intensity of the first magnetic field of the first standing wave and the intensity of the first electric field are both weakened. Therefore, the overall intensity of the first standing wave is weakened, the propagation distance of the first standing wave is shortened, thereby effectively improving the interference problem caused by the first standing wave on the camera module 20.

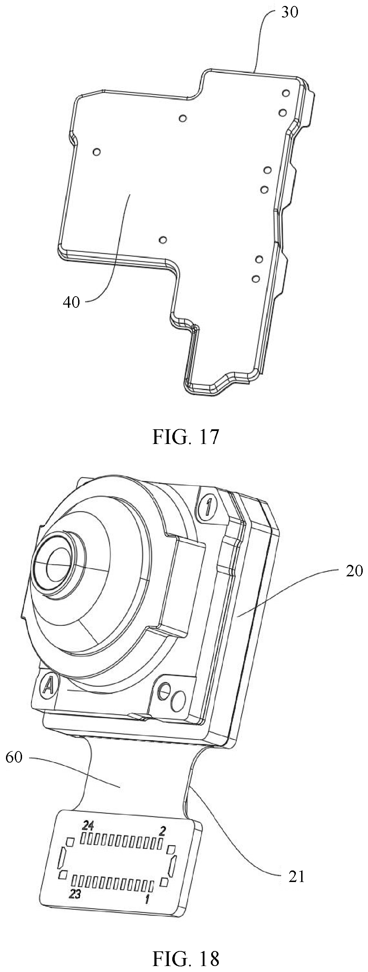

Referring to FIG. 1, FIG. 2, FIG. 3, FIG. 4, FIG. 16, and FIG. 17, FIG. 16 is a three-dimensional diagram of a decorative member in the housing assembly 100 shown in FIG. 1, and FIG. 17 is a three-dimensional diagram of a shielding cover in the housing assembly 100 shown in FIG. 1.

In some of the embodiments, the electrically conductive member 30 is at least one of a bracket, a main board 50, a decorative member, a heat sink, or a shielding cover. Through this setting, a problem that the camera module 20 is interfered can be better avoided.

It may be understood that, the first conduction loss member 40 may be disposed on the bracket, the main board 50, the decorative member, the heat sink, and the shielding cover, or the material may be the current loss material; or the first conduction loss member 40 may be disposed on one or two or more of the bracket, the main board 50, the decorative member, the heat sink, and the shielding cover, or the material may be the current loss material. The bracket, the main board 50, the decorative member, the heat sink, and the shielding cover are all conductive. The antenna 10 may excite the standing wave on the bracket, the main board 50, the decorative member, the heat sink, and the shielding cover. However, a direction of the standing wave is related to a type, a size, and a shape of the electrically conductive member 30.

When the first conduction loss member 40 is disposed on the decorative member and the heat sink, because the first current generated on the decorative member and the heat sink is mainly located at edges of the decorative member and the heat sink, the first conduction loss member 40 may be disposed at edge positions of the decorative member and the heat sink.

Specifically, the bracket may be understood as a structural member used for supporting and fixing main components such as a display screen, the main board 50, and a battery in the electronic device. As an important part in the electronic device, the bracket needs to have a precise size and shape, to ensure stability and reliability of components in the device. A design of the bracket also needs to consider practicability and an appearance of the device.

The main board 50 is a circuit board inside the electronic device, and mainly includes electronic elements such as a chip, a transistor, a capacitor, and a resistance. The main board 50 usually includes parts such as a processor, an internal memory, a memory, and a graphics card. The processor is a core of the electronic device, and is responsible for data processing and computing. The internal memory provides a temporary storage space, and is configured to store a running program and data. The memory is configured to store data for a long time. The graphics card is responsible for image processing and display. In addition, parts such as a power management chip, an audio processing chip, a Bluetooth chip, and a WIFI chip may further be integrated on the main board 50.

The decorative member may be made of a metal material, and is located between the rear-facing camera module 20 and a rear cover of the device housing 70. A main function of the decorative member is to protect the rear-facing camera module 20, and provide a metal decorative effect, thereby enhancing overall aesthetics of the device.

The heat sink is an important element for heat dissipation inside the electronic device. The heat sink is usually made of a material having good thermal conductivity such as graphites, and can evenly spread heat inside the device to a larger area, thereby effectively transferring the heat to the outside, and maintaining a normal operating temperature of the electronic device. The heat sink is generally used in high heating regions such as a central processing unit (Central Processing Unit, CPU) and a graphics processing unit (Graphics Processing Unit, GPU) of the mobile phone, to help rapidly dissipate heat in these regions.

The shielding cover is an important element inside the electronic device, and a main function of the shielding cover is to prevent an interference electromagnetic field from spreading outward. The shielding cover is usually made of a metal or a conductive material, can effectively block electromagnetic interference generated inside from being transmitted to the outside, and can also prevent impact of external electromagnetic interference on the inside of the device. By using the shielding cover, impact of electromagnetic interference on performance of the electronic device can be greatly reduced, and stability and reliability of the device can be ensured.

It may be understood that, when a size of the electrically conductive member 30 is within an electric size range of the standing wave mode in a radio frequency band of the electronic device, the electromagnetic wave emitted by the antenna 10 easily forms the standing wave mode in these electrically conductive members 30, to generate the first standing wave, and extremely strong near field coupling easily occurs between the first standing wave and the camera module 20. A related coupled noise electromagnetic field is loaded on the MIPI line of the camera module 20, causing the interference problem in the camera module 20.

Referring to FIG. 1, FIG. 2, and FIG. 18, FIG. 18 is a three-dimensional diagram of a camera module 20 in the housing assembly 100 shown in FIG. 1.

According to a second aspect, an embodiment of this application provides an anti-interference structure, where the anti-interference structure includes an antenna 10 and a camera module 20, an electromagnetic wave radiated by the antenna 10 may excite, on the camera module 20, a second standing wave propagating in a second direction, the second standing wave includes a second electric field, and the second electric field is capable of causing a second current flowing in the second direction to be generated on a side of the camera module 20 facing the second standing wave.

The interference structure includes a second conduction loss member 60, the second conduction loss member 60 is located on the side of the camera module 20 facing the second standing wave, and a material of the second conduction loss member 60 is a current loss material; or a material of a part of the side of the camera module 20 facing the second standing wave is a current loss material.

According to the anti-interference structure provided in this embodiment of this application, the anti-interference structure includes the second conduction loss member 60, the second conduction loss member 60 is located on the side of the camera module 20 facing the second standing wave, and the material of the second conduction loss member 60 is the current loss material, or the material of the part of the side of the camera module 20 facing the second standing wave is the current loss material. Therefore, when the electromagnetic wave radiated by the antenna 10 excites, on the camera module 20, the second standing wave propagating in the second direction, the current loss material may convert the second current generated by the second electric field of a part of the second standing wave on the camera module 20 into thermal energy, to prevent the second current from forming a changing second magnetic field again, so that an intensity of the second magnetic field and an intensity of the second electric field of the second standing wave are both weakened. Therefore, an overall intensity of the second standing wave is weakened, and a propagation distance of the second standing wave is shortened. In this way, superposition of the second electric field/second magnetic field and an electric field/a magnetic field that carries an image information signal and that is on an MIPI line of the camera module 20 is avoided, thereby effectively improving an interference problem caused by the second standing wave on the camera module 20.

It may be understood that a reason for generating the second standing wave is similar to a reason for generating the first standing wave. The material of the second conduction loss member 60 may be similar to the material of the first conduction loss member 40. The second conduction loss member 60 may be bonded on an outer surface of a flexible printed circuit board 21 in the camera module 20.

It should be noted that, the second direction may be the same as or different from the first direction. The anti-interference structure provided in this embodiment of this application may include both the first conduction loss member 40 and the second conduction loss member 60.

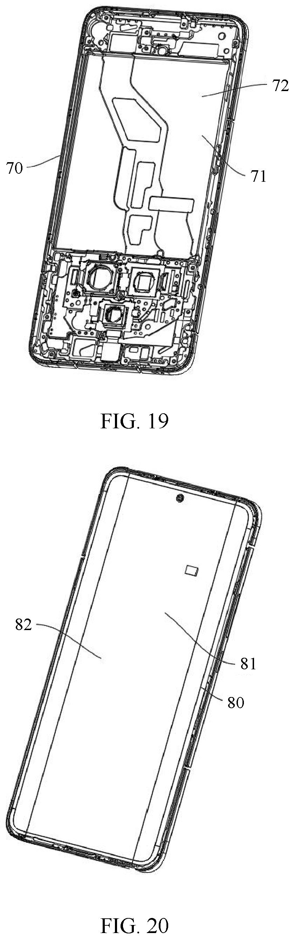

Referring to FIG. 1, FIG. 2, and FIG. 19, FIG. 19 is a three-dimensional diagram of the housing assembly 100 shown in FIG. 1 from another perspective.

According to a third aspect, Embodiment 1 of this application provides a housing assembly 100. The housing assembly 100 includes a housing 70 and the anti-interference structure according to the first aspect or the second aspect, where the anti-interference structure is connected to the housing 70.

According to the housing assembly 100 provided in this embodiment of this application, the anti-interference structure includes the first conduction loss member 40, the first conduction loss member 40 is located on the side of the electrically conductive member 30 facing the first standing wave, and the material of the first conduction loss member 40 is the current loss material, or the material of the part of the side of the electrically conductive member 30 facing the first standing wave is the current loss material. Therefore, when the electromagnetic wave radiated by the antenna 10 excites, on the electrically conductive member 30, the first standing wave propagating in the first direction, the current loss material may convert the first current generated by the first electric field of the part of the first standing wave on the electrically conductive member 30 into thermal energy, to prevent the first current from forming a changing first magnetic field again, so that an intensity of the first magnetic field and an intensity of the first electric field of the first standing wave are both weakened. Therefore, an overall intensity of the first standing wave is weakened, and a propagation distance of the first standing wave is shortened. In this way, superposition of the first electric field/first magnetic field and an electric field/a magnetic field that carries an image information signal and that is on an MIPI line of the camera module 20 is avoided, thereby effectively improving an interference problem caused by the first standing wave on the camera module 20.

According to the housing assembly 100 provided in this embodiment of this application, the anti-interference structure includes the second conduction loss member 60, the second conduction loss member 60 is located on the side of the camera module 20 facing the second standing wave, and the material of the second conduction loss member 60 is the current loss material, or the material of the part of the side of the camera module 20 facing the second standing wave is the current loss material. Therefore, when the electromagnetic wave radiated by the antenna 10 excites, on the camera module 20, the second standing wave propagating in the second direction, the current loss material may convert the second current generated by the second electric field of a part of the second standing wave on the camera module 20 into thermal energy, to prevent the second current from forming a changing second magnetic field again, so that an intensity of the second magnetic field and an intensity of the second electric field of the second standing wave are both weakened. Therefore, an overall intensity of the second standing wave is weakened, and a propagation distance of the second standing wave is shortened. In this way, superposition of the second electric field/second magnetic field and an electric field/a magnetic field that carries the image information signal and that is on the MIPI line of the camera module 20 is avoided, thereby effectively improving an interference problem caused by the second standing wave on the camera module 20.

It may be understood that, the anti-interference structure may be entirely disposed inside the housing 70; or the housing 70 includes a middle frame 71, a part of the camera module 20 is clamped to the housing 70, the electrically conductive member 30 may be bonded to the main board 50 inside the housing 70, the first conduction loss member 40 is bonded to the electrically conductive member 30, the second conduction loss member 60 is bonded to the camera module 20, and the antenna 10 is integrally formed with the middle frame 71 of the housing 70.

Still referring to FIG. 1, FIG. 2, and FIG. 19, in this embodiment, the electromagnetic wave radiated by the antenna 10 may excite, on the housing 70, a third standing wave propagating in a third direction, the third standing wave includes a third electric field, and the third electric field is capable of causing a third current flowing in the third direction to be generated on a side of the housing 70 facing the third standing wave.

The anti-interference structure includes a third conduction loss member 72, the third conduction loss member 72 is located on a side of the housing 70 facing the third standing wave, and a material of the third conduction loss member 72 is a current loss material; or a material of a part of the housing 70 facing the third standing wave is a current loss material.

By using the foregoing solution, when the electromagnetic wave radiated by the antenna 10 excites, on the housing 70, the third standing wave propagating in the third direction, the current loss material may convert, on the housing 70, the third current generated by the third electric field of a part of the third standing wave into thermal energy, to prevent the third current from forming a changing third magnetic field again, so that an intensity of the third magnetic field of the third standing wave and an intensity of the third electric field are both weakened. Therefore, an overall intensity of the third standing wave is weakened, a propagation distance of the third standing wave is shortened. In this way, superimposition of the third electric field/third magnetic field and an electric field/a magnetic field that carries the image information signal and that is on the MIPI line of the camera module 20 is avoided, thereby effectively improving an interference problem caused by the third standing wave on the camera module 20.

It may be understood that a reason for generating the third standing wave is similar to a reason for generating the first standing wave. The material of the third conduction loss member 72 may be similar to the material of the first conduction loss member 40. The third conduction loss member 72 may be bonded to the middle frame 71 of the housing 70.

It should be noted that, the third direction may be the same as or different from the first direction. The housing assembly 100 provided in this embodiment of this application may include all of the first conduction loss member 40, the second conduction loss member 60, and the third conduction loss member 72.

Referring to FIG. 1, FIG. 2, and FIG. 20, FIG. 20 is a three-dimensional exploded view of the housing assembly 100 shown in FIG. 1 from still another perspective.

According to a fourth aspect, an embodiment of this application provides an electronic device, and the electronic device includes the housing assembly 100 according to the third aspect.

According to the electronic device provided in this embodiment of this application, the anti-interference structure includes the first conduction loss member 40, the first conduction loss member 40 is located on the side of the electrically conductive member 30 facing the first standing wave, and the material of the first conduction loss member 40 is the current loss material, or the material of the part of the electrically conductive member 30 facing the first standing wave is the current loss material. Therefore, when the electromagnetic wave radiated by the antenna 10 excites, on the electrically conductive member 30, the first standing wave propagating in the first direction, the current loss material may convert the first current generated by the first electric field of a part of the first standing wave on the electrically conductive member 30 into thermal energy, to prevent the first current from forming a changing first magnetic field again, so that an intensity of the first magnetic field and an intensity of the first electric field of the first standing wave are both weakened. Therefore, an overall intensity of the first standing wave is weakened, and a propagation distance of the first standing wave is shortened. In this way, superposition of the first electric field/first magnetic field and an electric field/a magnetic field that carries an image information signal and that is on an MIPI line of the camera module 20 is avoided, thereby effectively improving an interference problem caused by the first standing wave on the camera module 20.

According to the electronic device provided in this embodiment of this application, the anti-interference structure includes the second conduction loss member 60, the second conduction loss member 60 is located on the side of the camera module 20 facing the second standing wave, and the material of the second conduction loss member 60 is the current loss material, or the material of the part of the camera module 20 facing the second standing wave is the current loss material. Therefore, when the electromagnetic wave radiated by the antenna 10 excites, on the camera module 20, the second standing wave propagating in the second direction, the current loss material may convert the second current generated by the second electric field of a part of the second standing wave on the camera module 20 into thermal energy, to prevent the second current from forming a changing second magnetic field again, so that an intensity of the second magnetic field and an intensity of the second electric field of the second standing wave are both weakened. Therefore, an overall intensity of the second standing wave is weakened, and a propagation distance of the second standing wave is shortened. In this way, superposition of the second electric field/second magnetic field and an electric field/a magnetic field that carries the image information signal and that is on the MIPI line of the camera module 20 is avoided, thereby effectively improving an interference problem caused by the second standing wave on the camera module 20.

It may be understood that, the anti-interference structure of the housing assembly 100 may include the third conduction loss member 72. When the electromagnetic wave radiated by the antenna 10 excites, on the housing 70, the third standing wave propagating in the third direction, the current loss material may convert the third current generated by the third electric field of a part of the third standing wave on the housing 70 into thermal energy, to prevent the third current from forming a changing third magnetic field again, so that an intensity of the third magnetic field of the third standing wave and an intensity of the third electric field are both weakened. Therefore, an overall intensity of the third standing wave is weakened, and a propagation distance of the third standing wave is shortened, thereby effectively improving an interference problem caused by the third standing wave on the camera module 20.

It should be noted that, the electronic device provided in this embodiment of this application may further include a battery, a microphone, a receiver assembly, and the like that are disposed in the housing 70.

Referring to FIG. 1, FIG. 2, and FIG. 20, in this embodiment, the electronic device includes a screen module 80. The antenna 10 may excite, on the screen module 80, a fourth standing wave propagating in a fourth direction, the fourth standing wave includes a fourth electric field, and the fourth electric field is capable of causing a fourth current flowing in the fourth direction to be generated on a side of the screen module 80 facing the fourth standing wave.

The anti-interference structure includes a fourth conduction loss member 82, the fourth conduction loss member 82 is located on the side of the screen module 80 facing the fourth standing wave, and a material of the fourth conduction loss member 82 is a current loss material; or a material of a part of the side of the screen module 80 facing the fourth standing wave is a current loss material.

By using the foregoing solution, when the antenna 10 excites, on the screen module 80, the fourth standing wave propagating in the fourth direction, the current loss material may convert the fourth current generated by the fourth electric field of a part of the fourth standing wave on the screen module 80 into thermal energy, to prevent the fourth current from forming a changing fourth magnetic field again, so that an intensity of the fourth magnetic field of the fourth standing wave and an intensity of the fourth electric field are both weakened. Therefore, an overall intensity of the fourth standing wave is weakened, a propagation distance of the fourth standing wave is shortened. In this way, superimposition of the fourth electric field/fourth magnetic field and an electric field/a magnetic field that carries an image information signal and that is on an MIPI line of the camera module 20 is avoided, thereby effectively improving an interference problem caused by the fourth standing wave on the camera module 20.

Specifically, the screen module 80 includes a screen 81, and the fourth conduction loss member 82 is bonded to a rear surface of the screen 81.

It may be understood that a reason for generating the fourth standing wave is similar to a reason for generating the first standing wave, and the material of the fourth conduction loss member 82 may be similar to the material of the first conduction loss member 40. The screen module 80 may include the screen 81, and the fourth conduction loss member 82 may be bonded to the screen 81.

It should be noted that, the fourth direction may be the same as or different from the first direction. The electronic device provided in this embodiment of this application may include all of the first conduction loss member 40, the second conduction loss member 60, the third conduction loss member 72, and the fourth conduction loss member 82. In other words, the electromagnetic wave radiated by the antenna 10 may excite the first standing wave propagating in the first direction on the electrically conductive member 30, may excite the second standing wave propagating in the second direction on the camera module 20, may excite the third standing wave propagating in the third direction on the housing 70, or may excite the fourth standing wave propagating in the fourth direction on the screen module 80. The first conduction loss member 40 may improve the interference problem caused by the first standing wave on the camera module 20, the second conduction loss member 60 may improve the interference problem caused by the second standing wave on the camera module 20, the third conduction loss member 72 may improve the interference problem caused by the third standing wave on the camera module 20, and the fourth conduction loss member 82 may improve the interference problem caused by the fourth standing wave on the camera module 20.

The foregoing descriptions are merely a specific implementation of this application, but are not intended to limit the protection scope of this application. Any variation or replacement readily figured out by a person skilled in the art within the technical scope disclosed in this application shall fall within the protection scope of this application.

## Claims

1. An anti-interference structure, wherein the anti-interference structure comprises an antenna, a camera module, and an electrically conductive member, wherein the electrically conductive member is located in a space between the antenna and the camera module, an electromagnetic wave radiated by the antenna is capable of exciting, on the electrically conductive member, a first standing wave propagating in a first direction, the first standing wave comprises a first electric field, and the first electric field is capable of causing a first current flowing in the first direction to be generated on a side of the electrically conductive member facing the first standing wave, wherein
the anti-interference structure comprises a first conduction loss member, the first conduction loss member is located on the side of the electrically conductive member facing the first standing wave, and a material of the first conduction loss member is a current loss material; or a material of a part of the side of the electrically conductive member facing the first standing wave is a current loss material.

2. The anti-interference structure according to claim 1, wherein a conductivity of the current loss material in the first direction is less than or equal to 8000 S/m within a temperature range of -50 °C to 200 °C.

3. The anti-interference structure according to claim 2, wherein the conductivity of the current loss material in the first direction is less than or equal to 3000 S/m.

4. The anti-interference structure according to claim 1, wherein the anti-interference structure comprises a first conduction loss member, the first conduction loss member is located on the side of the electrically conductive member facing the first standing wave, a material of the first conduction loss member is a current loss material, and the first conduction loss member is disposed on the side of the electrically conductive member facing the first standing wave by adhesion, soldering, snap-fit, threaded connection, or evaporation.

5. The anti-interference structure according to claim 1, wherein the anti-interference structure comprises a first conduction loss member, the first conduction loss member is located on the side of the electrically conductive member facing the first standing wave, a material of the first conduction loss member is a current loss material, and a distance between the first conduction loss member and the electrically conductive member is less than or equal to 2 mm.

6. The anti-interference structure according to claim 5, wherein the first conduction loss member is disposed on an outer surface of the electrically conductive member.

7. The anti-interference structure according to any one of claims 1 to 6, wherein the electrically conductive member is at least one of a bracket, a main board, a decorative member, a heat sink, or a shielding cover.

8. The anti-interference structure according to any one of claims 1 to 6, wherein the current loss material is one of an alloy material, a semiconductor material, and a clay material.

9. An anti-interference structure, wherein the anti-interference structure comprises an antenna and a camera module, an electromagnetic wave radiated by the antenna is capable of exciting, on the camera module, a second standing wave propagating in a second direction, the second standing wave comprises a second electric field, and the second electric field is capable of causing a second current flowing in the second direction to be generated on a side of the camera module facing the second standing wave, wherein
the anti-interference structure comprises a second conduction loss member, the second conduction loss member is located on the side of the camera module facing the second standing wave, and a material of the second conduction loss member is a current loss material; or a material of a part of the side of the camera module facing the second standing wave is a current loss material.

10. A housing assembly, wherein the housing assembly comprises:
a housing; and
the anti-interference structure according to any one of claims 1 to 9, wherein the anti-interference structure is connected to the housing.

11. The housing assembly according to claim 10, wherein the electromagnetic wave radiated by the antenna is capable of exciting, on the housing, a third standing wave propagating in a third direction, the third standing wave comprises a third electric field, and the third electric field is capable of causing a third current flowing in the third direction to be generated on a side of the housing facing the third standing wave, wherein
the anti-interference structure comprises a third conduction loss member, the third conduction loss member is located on the side of the housing facing the third standing wave, and a material of the third conduction loss member is a current loss material; or a material of a part of the side of the housing facing the third standing wave is a current loss material.

12. An electronic device, wherein the electronic device comprises the housing assembly according to claim 10 or 11.

13. The electronic device according to claim 12, wherein the electronic device comprises a screen module, the electromagnetic wave radiated by the antenna is capable of exciting, on the screen module, a fourth standing wave propagating in a fourth direction, the fourth standing wave comprises a fourth electric field, and the fourth electric field is capable of causing a fourth current flowing in the fourth direction to be generated on a side of the screen module facing the fourth standing wave, wherein
the anti-interference structure comprises a fourth conduction loss member, the fourth conduction loss member is located on the side of the screen module facing the fourth standing wave, and a material of the fourth conduction loss member is a current loss material; or a material of a part of the side of the screen module facing the fourth standing wave is a current loss material.
